# EUROPEAN PATENT APPLICATION

(11) **EP 4 717 748 A1**
(43) Date of publication of application: **01.04.2026**
(21) Application number: 25193613.4
(22) Date of filing: 02.08.2025
(51) Int. Cl.: C09K 11/61, C09K 11/80, H10H 29/851

(54) **WHITE LIGHT EMITTING DEVICES WITH ENHANCED COLOR QUALITY**

(30) Priority: 05.08.2024 US 202463679558 P
(71) Applicant: Bridgelux, Inc., Fremont, CA 94538 (US)
(72) Inventor: LI, Yi-Qun, Danville, CA 94526 (US)
(74) Representative: Birdi, Sandeep Singh

(57) **Abstract**

A light emitting device comprising: an LED for generating blue light; a green phosphor for generating green light; and a manganese activated fluoride narrowband phosphor for generating red light; wherein a ratio of a maximum intensity in the red region of the spectrum to a minimum intensity in the yellow to orange region of the spectrum is from about 5.0 to about 15.0.

## Description

### FIELD OF THE INVENTION

Embodiments of the invention concern white light emitting devices with enhanced color quality. More particularly, although not exclusively, embodiments relate to devices for generating light with enhanced color contrast.

### BACKGROUND OF THE INVENTION

White light emitting LEDs ("white LEDs") include one or more photoluminescence materials (typically inorganic phosphor materials), which absorb a portion of the blue light emitted by the LED and re-emit visible light of a different color (wavelength). The portion of the blue light generated by the LED that is not absorbed by the phosphor material combined with the light emitted by the phosphor provides light which appears to the eye as being white in color. Due to their long operating life expectancy (>50,000 hours) and high luminous efficacy (100 lumens per watt and higher), white LEDs are rapidly replacing conventional fluorescent, compact fluorescent and incandescent lamps.

Luminous efficacy is a measure of how well a light source generates visible light and is the ratio of luminous flux to power and has units of lumens per watt (lm/W). The power can be either the radiant power of light generated by the source or electrical power consumed by the source. When the power is radiant power, the luminous efficacy is referred to as the Luminous Efficacy of Radiation (LER), often simply referred to as Luminous Efficacy (LE), and has units of lm/Wₒₚₜ. When the power is electrical power, the luminous efficacy is referred to as the Overall Luminous Efficacy (OLE) of the light source or luminous efficacy of a source and has units of lm/W_{dc}.

In the past 15 years, improvement of OLE of white LED light sources have relied on improvement of blue LED chip efficiency, phosphor efficiency, and package light extraction efficiency. During this period of the past 15 years to the present day, OLE steadily increased from 60 lm/W_{dc} to 200 lm/W_{dc} (LER ~ 300 lm/Wₒₚₜ). However, blue LED chips and phosphor efficiency have essentially reached their limit with little prospect of further improvement.

With the widespread popularity of LED lighting, the demand for white LED light sources is no longer limited to high luminous efficacy and low cost, but also requires high light quality.

Various metrics exist for quantifying the characteristics and quality of light generated by white lighting sources. The two most used metrics within the solid-state lighting industry are Correlated Color Temperature (CCT) and International Commission on Illumination (CIE) General Color Rendering Index (CRI) Ra.

The CCT of a lighting source is measured in kelvin (K) and is the temperature of a Planckian (blackbody) radiator that radiates light of a color that corresponds to the color of the light generated by the lighting source.

The General CRI Ra characterizes how faithfully a lighting source renders the true colors of an object and is based on a measure of how well a lighting source's illumination of eight color test samples (R1 to R8) compares with the illumination provided by a reference source. In general, the higher the value indicates its closeness to a black radiator and natural sunlight. General CRI Ra can take negative values and has a maximum value of 100. Since the color samples R1 to R8 are all pastel colors (low saturation colors "Light Grayish Red" to "Reddish Purple"), the General CRI Ra gives a useful measure of subtle differences in light output of incandescent sources which generate a full spectrum that closely resembles sunlight. However, for white LEDs whose spectrum is composed of peaks, the General CRI Ra is proving to be inadequate as it is an average measure of color rendition over a limited range of colors and gives no information of the lighting source's performance for particular colors or highly saturated colors. Thus, when characterizing full spectrum solid-state white light emitting devices the CRI color samples R9 to R12 (saturated colors "Saturated Red", "Saturated Yellow", "Saturated Green", "Saturated Blue") and R13 to R15 ("Light Skin Tone", "Leaf Green", "Medium Skin Tone") should be taken into account to give a meaningful characterization of full spectrum light.

To increase CRI Ra and CRI R9, it is known to include orange to red light emitting phosphors. Suitable phosphor materials include europium-activated nitride compounds, for example (Ba,Sr)₂Si₅N₈:Eu²⁺ (2:5:8) and (Ca,Sr)AlSiN₃:Eu²⁺ (CASN). However, while commonly used, these phosphors have some drawbacks since their emission spectra are broad (Full Width at Half Maximum, FWHM, is approximately 75 - 85 nm), a large part of their emission spectrum is at wavelengths longer than 650 nm - a part of the spectrum to which the human eye is insensitive - which significantly reduces the luminous efficacy (LER) of white LEDs based on such phosphors. Most recently, it is known to also include a narrowband red phosphor such as a manganese-activated potassium silicate fluoride phosphor to alleviate this problem and increase LER to ~ 300 lm/Wₒₚₜ today.

To address the limitations of General CRI Ra, the Illuminating Engineering Society (IES) recently published the TM-30 standard for measuring and characterizing the color performance of lighting sources (Illuminating Engineering Society (2015) "Method for Evaluating Light Source Color Rendition" TM-30-15). Under the TM-30-15 standard, two metrics are used to characterize the color rendering characteristics of a lighting source - Fidelity Index (R_{f}) and Gamut Index (R_{g}). It is believed that IES TM-30-15 method has better correlation with people's color perception and, therefore, gives a more accurate characterization of a lighting source's light characteristics. The Fidelity Index R_{f} is similar to General CRI Ra and characterizes how faithfully a lighting source renders the true colors of an object and is based on a measure of how well a lighting source's illumination of 99 color samples compares with the illumination provided by a reference source. The Fidelity Index R_{f} value ranges from 0 to 100. The new color samples have been selected to be more representative of objects that are likely to be encountered in real-life applications and, as a result, the Fidelity Index R_{f} is believed to be a more accurate measure of color rendering than the General CRI Ra. Since R_{f} is measured over a greater number of color samples, it will be more difficult to achieve high scores compared with the General CRI Ra. Moreover, due to the different testing procedures, General CRI Ra and Fidelity Index R_{f} values are not comparable against each other.

The Gamut Index R_{g} focuses on color saturation and is an average level of saturation compared with a reference source. The Gamut Index R_{g} correlates to the vividness of the appearance of colored objects. The Gamut Index R_{g} value ranges from 60 to 140 where values below 100 indicate decreased saturation and values above 100 indicate increased saturation compared with the reference source.

USA patents US 7,453,195 B2 and US 9,954,145 B2 describe white lamps with enhanced color contrast.

US 7,453,195 B2 concerns white lamps comprising a semiconductor light source (LED) with a peak emission from about 250 nm to about 500 nm, a first phosphor having a peak emission between about 550 nm and 615 nm (i.e., green to orange region of the visible spectrum), and a second phosphor having a peak emission in a range from about 615 nm to 670 nm (i.e., orange to red region of the visible spectrum). The lamp has an overall emission spectrum having a depression in intensity in the yellow portion of the visible spectrum for wavelengths between about 550 and 615 nm that extends to between about 5% and 25% of the highest intensity of the emission spectrum of the lamp for wavelengths between 400 to 700 nm. The reduced emission in the yellow portion of the visible spectrum increases red-green contrast in emitted light which is believed to impart qualities which are desirable to consumers.

US 9,954,145 B2 describes white lamps comprising a semiconductor light source (LED) with a peak emission from about 250 nm to about 500 nm, a first phosphor having a peak emission between about 550 nm and 615 nm, a second red phosphor having a peak emission in a range from about 615 nm to 670 nm, a third blue phosphor having a peak emission in a range from about 450 nm to 550 nm, and a filter comprising a layer of neodymium glass. The filter prevents emission of a portion of light in the yellow region of the visible spectrum that is emitted by the first phosphor while substantially permitting emission of light from the lamp for wavelengths other than between 550 nm to 615 nm. The filter induces a depression in the yellow portion of the visible spectrum for wavelengths between 550 nm to 615 nm and increases red-green contrast in emitted light which is believed to impart qualities which are desirable to consumers.

US 11,054,090 teaches a high gamut index white light emitting device comprising: a solid-state source (e.g., LED) for generating blue light having a dominant wavelength from 440 nm to 455 nm; a first photoluminescence material (phosphor) for generating green light having a peak emission wavelength from 500 nm to 530 nm; and a second photoluminescence material (phosphor) for generating red light having a peak emission wavelength from 640 nm to 690 nm. The device is for generating white light of a selected color temperature with an IEC TM-30 Gamut Index Rg from 105 to 115 and a Fidelity Index Rf from 85 to 95. White light generated by the device has a spectrum having a first region in a wavelength range from 508 nm to 555 nm (i.e., green portion of the visible spectrum) with an intensity that is greater than an intensity of a Planckian spectrum of the selected color temperature and a second region in a wavelength range from 560 nm to 600 nm (i.e., green to orange region of the visible spectrum) with an intensity that is less than the intensity of the Planckian spectrum. The chromaticity of light generated by the device has a chromaticity that is 1 to 3 MacAdam ellipses lower than the blackbody curve of the selected color temperature on a CIE 1931 chromaticity diagram.

The present invention arose in an endeavor to provide solid-state white light emitting devices comprising photoluminescence wavelength conversion materials that generate white light with enhanced color quality having a high Gamut Index R_{g} that is above 100, for example at least 105, and have a high luminous efficacy of radiation (LER) of, for example, at least 300 lm/Wₒₚₜ.

### SUMMARY OF THE INVENTION

Embodiments of the invention concern white light emitting devices comprising: a solid-state excitation source (e.g., LED chip) for generating blue light having, for example, a dominant wavelength ranging from 420 nm to 480 nm (i.e., in the blue region of the visible spectrum); a first photoluminescence material (typically a phosphor) for generating light having, for example, a peak emission wavelength ranging from 500 nm to 565 nm (i.e., in the green region of the visible spectrum); and a manganese activated fluoride narrowband red phosphor for generating red light having, for example, a peak emission wavelength from 628 nm to 640 nm (i.e., in red region of the visible spectrum) and, optionally, a full width at half maximum of less than 30 nm. It may be that the device is for generating white light of a selected color temperature (e.g., 2200K to 6500K) with a Gamut Index, Rg, of at least 105 and the device has an LER of at least 300 lm/Wₒₚₜ. A Gamut Index R_{g} above 100 indicates that the light emitting device generates light having a color saturation that is greater than that of a Planckian (blackbody) radiator of the same color temperature resulting in more vivid colors of illuminated objects. Such an increase in vividness of selected colors can be desirable in many applications such as, for example, in retail lighting to enhance the appearance of a product.

According to an aspect of the invention, there is contemplated a light emitting device comprising: an LED for generating blue light; a green phosphor for generating green light; and a manganese activated fluoride narrowband phosphor for generating red light; wherein the device is for generating light having an intensity versus wavelength spectrum with a ratio of a maximum intensity in the red region of the spectrum to a minimum intensity in the yellow to orange region of the spectrum is from about 5.0 to about 15.0.

It may be that the manganese activated fluoride narrowband phosphor is selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

The device may have a Luminous Efficacy of Radiation, LER, of at least 300 lm/Wₒₚₜ and may be for generating light with an IES TM-30-15 Gamut Index, R_{g}, of at least 105 or an IES TM-30-15 Gamut Index, R_{g}, from 105 to 120.

It may be that at least one of the following applies: the ratio of the maximum intensity in the red region of the spectrum to the minimum intensity in the yellow to orange region of the spectrum is about 11.0 to about 15.0 and the device is for generating light with a CRI Ra of at least 70; the ratio of the maximum intensity in red region of the spectrum to the minimum intensity in the yellow to orange region of the spectrum is about 8.0 to about 11.0 and the device is for generating light with a CRI Ra of at least 80; and the ratio of the maximum intensity in red region of the spectrum to the minimum intensity in the yellow to orange region of the spectrum is about 5.0 to about 8.0 and the device is for generating light with a CRI Ra of at least 90.

It may be that at least one of the following applies: a ratio of a maximum intensity in a red region of the spectrum to a maximum intensity in a green region of the spectrum is from 6.0 to 10.0; a ratio of a maximum intensity in a green region of the spectrum to a minimum intensity in a yellow to orange region of the spectrum is about 1.0 to about 1.5; a ratio of a maximum intensity in a blue region of the spectrum to a minimum intensity in a cyan region of the spectrum is from about 4.0 to about 6.0; and a ratio of a maximum intensity in a green region of the spectrum to a maximum intensity in a blue region of the spectrum is from about 1.0 to about 1.2.

According to an aspect of the invention, there is provided light emitting device comprising: an LED for generating blue light; a green phosphor for generating green light; and a manganese activated fluoride narrowband phosphor for generating red light; wherein the device is for generating light of a selected color temperature having an intensity versus wavelength spectrum comprising: an intensity in a green region of the spectrum that is greater than an intensity of the Planckian spectrum of the selected color temperature; an intensity in a yellow to orange region of the spectrum that is less than an intensity of the Planckian spectrum of the selected color temperature; and an intensity in a red region of the spectrum that is greater than an intensity of the Planckian spectrum of the selected color temperature; and it may be that at least one of following applies: a maximum intensity in the green region is 110% to 150% of the intensity of the Planckian spectrum; a minimum intensity in the yellow to orange region is 50% to 80% of the intensity of the Planckian spectrum; and a maximum intensity in the red region is 400% to 600% of the intensity of the Planckian spectrum.

The manganese activated fluoride narrowband phosphor may be selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

The green region may be from 500 nm to 565 nm; the yellow to orange region may be from 550 nm to 609 nm; and the red region may be from 605 nm to 640 nm.

The device may have a Luminous Efficacy of Radiation, LER, of at least 300 lm/Wₒₚₜ and may be for generating light with an IES TM-30-15 Gamut Index, R_{g}, of at least 105, or an IES TM-30-15 Gamut Index, R_{g}, from 105 to 120.

According to an aspect, the present invention envisages a light emitting device comprising: an LED for generating blue light; a green phosphor for generating green light; and a manganese activated fluoride narrowband phosphor for generating red light; wherein the device has a Luminous Efficacy of Radiation, LER, of at least 300 lm/Wₒₚₜ and is for generating light with an IES TM-30-15 Gamut Index, R_{g}, of at least 105.

The manganese activated fluoride narrowband phosphor may be selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

The device may be for generating light with an LER from 300 lm/Wₒₚₜ to 330 lm/Wₒₚₜ, and/or an R_{g} from 105 to 120.

It may be that at least one of the following applies: the device has an LER from 300 lm/Wₒₚₜ to 305 lm/Wₒₚₜ and is for generating light with a CRI Ra of at least 70 and an R_{g} of 115 to 120; the device has an LER from 305 lm/Wₒₚₜ to 315 lm/Wₒₚₜ and is for generating light with a CRI Ra of at least 80 and an R_{g} of 115 to 120; and the device has an LER from 315 lm/Wₒₚₜ to 330 lm/Wₒₚₜ and is for generating light with a CRI Ra of at least 90 and an R_{g} of 105 to 115.

The manganese activated fluoride narrowband phosphor may comprise from 55 wt% to 75 wt% of a total phosphor content.

The green phosphor may comprise from 25 wt% to 45 wt% of a total phosphor content.

The device may comprise an orange phosphor for generating orange light, optionally with a peak emission wavelength from 600 nm to 620 nm, and optionally the orange phosphor may comprise from 25 wt% to 45 wt% of a total phosphor content.

According to an aspect of the invention a light emitting device comprises: an LED for generating blue light; a green phosphor for generating green light; and a narrowband red phosphor for generating red light selected from the group consisting of: K₂SiF₆:Mn⁴⁺, K₂GeF₆:Mn⁴⁺, and K₂TiF₆:Mn⁴⁺; wherein the device has a Luminous Efficacy of Radiation of at least 300 lm/Wₒₚₜ and is for generating light with an IES TM-30-15 Gamut Index of at least 105.

It may be that the device is for generating white light of a with an IES TM-30-15 Gamut Index (R_{g}) from 105 to 120.

It may be that the device has a Luminous Efficacy of Radiation from 300 lm/Wₒₚₜ to 330 lm/Wₒₚₜ.

Where the device is for generating light with a General Color Rendering Index (CRI Ra) of at least 70 and a IES TM-30-15 Gamut Index (R_{g}) of 115 to 120 the device may have a Luminous Efficacy of Radiation (LER) from 300 lm/Wₒₚₜ to 305 lm/Wₒₚₜ.

Where the device is for generating light with a CRI Ra of at least 80 and a IES TM-30-15 Gamut Index (R_{g}) of 115 to 120 the device may have a Luminous Efficacy of Radiation (LER) from 305 lm/Wₒₚₜ to 315 lm/Wₒₚₜ.

Where the device is for generating light with a CRI Ra of at least 90 and a IES TM-30-15 Gamut Index (R_{g}) of 105 to 115 the device may have a Luminous Efficacy of Radiation LER from 315 lm/Wₒₚₜ to 330 lm/Wₒₚₜ.

The device can be configured to generate white light having a spectrum comprising one or more spectral features, such as a peak, a local minimum (trough) or point of inflection. Such spectral features can be selected to optimize color quality, gamut index, and/or LER.

In embodiments, a ratio of a maximum intensity in red region of the spectrum to a minimum intensity in the yellow to orange region of the spectrum may be about 5.0 to about 15.0.

Where the device is for generating light with a CRI Ra of at least 70, a ratio of a maximum intensity in red region of the spectrum to a minimum intensity in the yellow to orange region of the spectrum may be about 11.0 to about 15.0.

Where the device is for generating light with a CRI Ra of at least 80, a ratio of a maximum intensity in red region of the spectrum to a minimum intensity in the yellow to orange region of the spectrum may be about 8.0 to 11.0.

Where the device is for generating light with a CRI Ra of at least 90, a ratio of a maximum intensity in red region of the spectrum to a minimum intensity in the yellow to orange region of the spectrum may be 5.0 to 8.0.

Alternatively and/or in addition at least one of following may apply: a ratio of a maximum intensity in a red region of the spectrum to a maximum intensity in a green region of the spectrum is from 6.0 to 10.0; a ratio of a maximum intensity in green region of the spectrum to a minimum intensity in the yellow to orange region of the spectrum is about 1.0 to about 1.5; a ratio of a maximum intensity in blue region of the spectrum to a minimum intensity in the cyan region of the spectrum is from about 4.0 to about 6.0; or a ratio of a maximum intensity in green region of the spectrum to a maximum intensity in the blue region of the spectrum is from about 1.0 to about 1.2.

In embodiments, the device is for generating light of a selected color temperature having an intensity versus wavelength spectrum comprising: an intensity in a green region of the spectrum that is greater than an intensity of the Planckian spectrum of the selected color temperature; an intensity in a yellow to orange region of the spectrum that is less than an intensity of the Planckian spectrum of the selected color temperature; and an intensity in a red region of the spectrum that is greater than an intensity of the Planckian spectrum of the selected color temperature.

In embodiments, at least one of following may apply: the green region has a maximum intensity of 110% to 150% of the intensity of the Planckian spectrum; the yellow to orange region has a minimum intensity of 50% to 80% of the intensity of the Planckian spectrum; or the red region has a maximum intensity of 400% to 600% of the intensity of the Planckian spectrum.

It may be that the green region is from 500 nm to 565 nm; the yellow to orange region is from 550 nm to 609 nm; and the red region is from 605 nm to 640 nm.

The device may be for generating light having a chromaticity that is below the black body locus of the selected color temperature with a CIE 1976 Dᵤᵥ from -0.005 to -0.015.

In terms of device phosphor composition, the narrowband red phosphor may comprise from 55 wt% to 75 wt% of a total phosphor content. The green phosphor may comprise from 25 wt% to 45 wt% of a total phosphor content. The device may further a broadband orange phosphor for generating light with a peak emission wavelength from 600 nm to 620 nm. The orange phosphor comprises from 25 wt% to 45 wt% of a total phosphor content.

The broadband orange phosphor may comprise a nitride-based phosphor material having a general composition AAlSiN₃:Eu²⁺ where A is at least one of Ca, Sr or Ba.

The green phosphor may comprise a silicate phosphor of general composition (Sr₁₋ₓBaₓ)₂SiO₄:Eu or a cerium-activated garnet phosphor selected from the group consisting of: a phosphor of general composition (Y,Lu)₃(Al,Ga)₅O₁₂:Ce; a phosphor of general composition Y₃(Al,Ga)₅O₁₂:Ce; and a phosphor of general composition Lu₃Al₅O₁₂:Ce.

In embodiments, the narrowband red phosphor can be located in a separate location to that of the green phosphor, for example in a separate layer.

According to another aspect of the invention, a light emitting device comprises: an LED for generating blue light; a green phosphor for generating green light; and a narrowband red phosphor for generating red light selected from the group consisting of: K₂SiF₆:Mn⁴⁺, K₂GeF₆:Mn⁴⁺, and K₂TiF₆:Mn⁴⁺; wherein a ratio of a maximum intensity in red region of the spectrum to a minimum intensity in the yellow to orange region of the spectrum is about 5.0 to about 15.0.

Where the device is for generating light with a CRI Ra of at least 70 a ratio of a maximum intensity in red region of the spectrum to a minimum intensity in the yellow to orange region of the spectrum may be about 11.0 to about 15.0.

Where the device is for generating light with a CRI Ra of at least 80 a ratio of a maximum intensity in red region of the spectrum to a minimum intensity in the yellow to orange region of the spectrum may be about 8.0 to 11.0.

Where the device is for generating light with a CRI Ra of at least 90 a ratio of a maximum intensity in red region of the spectrum to a minimum intensity in the yellow to orange region of the spectrum may be 5.0 to 8.0.

Additionally, at least one of following may appliy: a ratio of a maximum intensity in a red region of the spectrum to a maximum intensity in a green region of the spectrum is from 6.0 to 10.0; a ratio of a maximum intensity in green region of the spectrum to a minimum intensity in the yellow to orange region of the spectrum is about 1.0 to about 1.5; a ratio of a maximum intensity in blue region of the spectrum to a minimum intensity in the cyan region of the spectrum is from about 4.0 to about 6.0; or a ratio of a maximum intensity in green region of the spectrum to a maximum intensity in the blue region of the spectrum is from about 1.0 to about 1.2.

It may be that the device has a Luminous Efficacy of Radiation (LER) of at least 300 lm/Wₒₚₜ and is for generating light with an IES TM-30-15 Gamut Index (R_{g}) of at least 105.

According to a further aspect of the invention a light emitting device comprises: an LED for generating blue light; a green phosphor for generating green light; and a narrowband red phosphor for generating red light selected from the group consisting of: K₂SiF₆:Mn⁴⁺, K₂GeF₆:Mn⁴⁺, and K₂TiF₆:Mn⁴⁺; wherein the device is for generating light of a selected color temperature having an intensity versus wavelength spectrum comprising: an intensity in a green region of the spectrum that is greater than an intensity of the Planckian spectrum of the selected color temperature; an intensity in a yellow to orange region of the spectrum that is less than an intensity of the Planckian spectrum of the selected color temperature; and an intensity in a red region of the spectrum that is greater than an intensity of the Planckian spectrum of the selected color temperature; and wherein at least one of following applies: a maximum intensity in the green region is 110% to 150% of the intensity of the Planckian spectrum; a minimum intensity in the yellow to orange region is 50% to 80% of the intensity of the Planckian spectrum; or a maximum intensity in the red region is 400% to 600% of the intensity of the Planckian spectrum.

It may be that the green region is in a wavelength range from 500 nm to 565 nm.

It may be that the yellow to orange region is in a wavelength range from 550 nm to 609 nm.

It may be that the red region is in a wavelength range from 605 nm to 640 nm.

In various aspects of the invention, the device may have a Luminous Efficacy of Radiation (LER) of at least 300 lm/Wₒₚₜ and may be for generating light with an IES TM-30-15 Gamut Index (R_{g}) of at least 105.

### BRIEF DESCRIPTION OF THE DRAWINGS

These and other aspects and features of the present invention will become apparent to those ordinarily skilled in the art upon review of the following description of specific embodiments of the invention in conjunction with the accompanying figures, in which:
**FIG. 1** is a sectional view of a packaged white light emitting device in accordance with an embodiment of the invention;
**FIG. 2A** and **2B** respectively show a plan view and a cross-sectional side view through A-A of COB (Chip On Board) packaged white light emitting device in accordance with an embodiment of the invention;
**FIG. 3** is a view of a CSP (Chip Scale Packaged) white light emitting device in accordance with an embodiment of the invention;
**FIG. 4** shows spectra, normalized intensity (a.u.) versus wavelength (nm), for light emitting device Dev.3 - 70 CRI (solid line) and a Planckian (blackbody) radiator (dashed line) of temperature T that is the same as the CCT of Dev.3 (2531 K);
**FIG. 5** shows spectra, normalized intensity versus wavelength (nm) for light emitting device Dev.4 - 80 CRI (solid line) and Planckian (blackbody) radiator (dashed line) of temperature T that is the same as the CCT of Dev.3 (2531 K); and
**FIG. 6** shows spectra, normalized intensity (a.u.) versus wavelength (nm), for: (i) light emitting device Dev.9 - 90 CRI (solid line) and Planckian (blackbody) radiator (dashed line) of temperature T that is the same as the CCT of Dev.4 (2770 K).

### DETAILED DESCRIPTION OF THE INVENTION

Embodiments of the present invention will now be described in detail with reference to the drawings, which are provided as illustrative examples of the invention so as to enable those skilled in the art to practice the invention. Notably, the figures and examples below are not meant to limit the scope of the present invention to a single embodiment, but other embodiments are possible by way of interchange of some or all of the described or illustrated elements. Moreover, where certain elements of the present invention can be partially or fully implemented using known components, only those portions of such known components that are necessary for an understanding of the present invention will be described, and detailed descriptions of other portions of such known components will be omitted so as not to obscure the invention. In the present specification, an embodiment showing a singular component should not be considered limiting; rather, the invention is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present invention encompasses present and future known equivalents to the known components referred to herein by way of illustration.

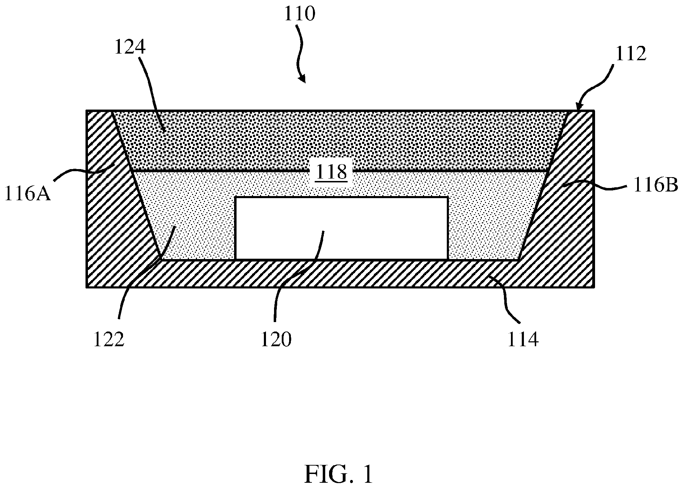

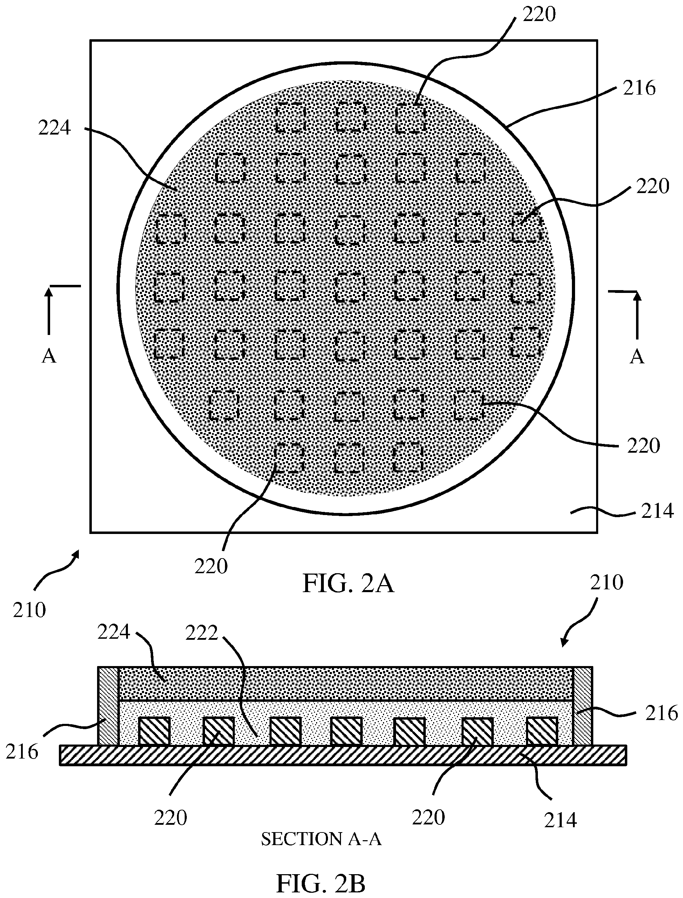

Throughout this specification like reference numerals are used to denote like parts preceded by the figure number #. For example, a light emitting device is denoted 110 in FIG. 1 is denoted 210 in FIG. 2 and so forth.

A light emitting device **110** in accordance with an embodiment of the invention are now described with reference to **FIG. 1** which shows a sectional side view of the device **110.** The light emitting device **110** is a package-type device, for example an SMD (Surface Mount Device) 2835 LED package **112.** The SMD package **112** comprises a housing comprising a rectangular base **114** and side walls **116A, 116B** extending upwardly from opposing edges of the rectangular base **114.** The interior surfaces of the side walls **116A, 116B** slope inwardly to their vertical axis and together with interior surface of the base **114** define a rectangular cavity (cup) **118.**

In this embodiment, the cavity **118** comprises one or more InGaN (indium gallium nitride) violet to blue (450 to 485 nm) LED dies **120,** a first photoluminescence material layer **122** comprising a manganese-activated fluoride narrowband red phosphor that covers the one or more LED dies **120,** and a second photoluminescence material layer **124** comprising a green phosphor that is disposed on and covers the first photoluminescence material layer **122.** As illustrated, the first photoluminescence material layer **122** may fill approximately at least 70% of the cavity **118** and the second photoluminescence material layer **124** may fill the remainder of the cavity.

In this way, there is provided a light emitting device **110** comprising: a blue LED **120;** a first photoluminescence material layer **122** comprising a manganese-activated fluoride narrowband red phosphor disposed on the LED **120** and a second photoluminescence material layer **124** comprising a green phosphor covering the first photoluminescence material layer **122.**

Providing the manganese-activated fluoride narrowband red phosphor as an individual layer significantly reduces the usage amount of the narrowband red phosphor compared with known arrangements in which the photoluminescence materials are provided as a mixture in a single layer. However, it is contemplated that in other embodiments, the manganese-activated fluoride narrowband red phosphor and the green phosphor may be provided as a mixture in a single layer. The first photoluminescence material layer **122** contains a majority, for example at least 75wt%, of manganese-activated fluoride narrowband red phosphor compared with other phosphors that may be in the layer. The first photoluminescence material layer **122** may contain other materials such as light scattering particles or light diffusive material for example. Typically, the amount of the other materials is no more than **30%** weight of the manganese-activated fluoride narrowband red phosphor. Further, in this embodiment, the first photoluminescence material layer **122** may be constituted by K₂SiF₆:Mn⁴⁺ (but equally may be constituted by one or a combination of K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺) and may be dispersed in dimethyl silicone. The first photoluminescence material layer **122** is directly in contact with and adjacent the LED **20.** There are no other photoluminescence material containing layers between the first photoluminescence material layer **122** and the LED **120.**

As described, in this embodiment, the device **110** also comprises a second photoluminescence material layer **124** disposed on top of the first photoluminescence material layer **122** and which fills the cavity **118.** In this embodiment, the photoluminescence material layer **124** comprises a broadband green phosphor. The second photoluminescence material layer **124** in addition to the broadband green phosphor may contain other minority orange phosphors.

In this embodiment, the light emitting device **110** thus constitutes a two-layer (multi-layer) photoluminescence structure. In this way, the light emitting device **110 is able to** effectively isolate the manganese-activated fluoride narrowband red phosphor in the first photoluminescence material layer **122** from direct contact with any water/moisture in the surrounding environment. Such a multi-layer or two-layer design of the light emitting device **110** provides an effective solution to address the poor moisture reliability of manganese-activated fluoride narrowband red phosphors in known constructions. Thus, the inclusion of the manganese-activated fluoride narrowband red phosphor in a separate photoluminescence material layer **124** provides the benefit of improved moisture reliability to the light emitting device (i.e., LED package) **110.**

It is to be noted that the first photoluminescence material layer **122** is in closer proximity to the LED **120** than any other photoluminescence material layer(s) including the second photoluminescence material layer **124;** that is the first photoluminescence material layer **122** is proximal (i.e. a proximal layer) to the LED **120,** while the second photoluminescence material layer **124** is distal (i.e., a distal layer) to the LED **120.**

The described light emitting device structure comprising a photoluminescence material layer comprising substantially only manganese-activated fluoride narrowband red phosphor limited to surface mount packaged devices. For instance, it can also be applied in Chip on Board (COB), Chip Scale Packaging (CSP) applications, or LED-Filaments.

With reference to **FIGS. 2A** and **2B****,** there is shown a plan view of a COB light emitting device **210** in accordance with another embodiment of the invention, and a cross-sectional side view through A-A (of **FIG. 2A**). The light emitting device **210** comprises a square substrate **214,** for example a Metal Core Printed Circuit Board (MCPCB). Forming a COB arrangement, 7 arrays (rows) of blue LED dies **220** are disposed on the substrate **214** as a circular array. The substrate **214** also comprises an annular wall **216** which encloses all the blue LED dies **220.**

A first photoluminescence material layer **222** comprising a manganese-activated fluoride narrowband red phosphor is deposited onto the substrate **214** and, in this embodiment, completely covers the LEDs **220.** Similarly, a second photoluminescence material layer **224** comprising a green phosphor is deposited onto first photoluminescence material layer **224.** In this way, the first photoluminescence material layer **222** and the second photoluminescence material layer **224** are located on top of one another and also contained inside the wall **216.**

The light emitting device **210** functions and exhibits the same advantages as discussed in relation the light emitting device of **FIG. 1** for example. Hence, the statement made in relation to **FIG. 1** apply equally to the embodiment of **FIGS. 2A** and **2B****.**

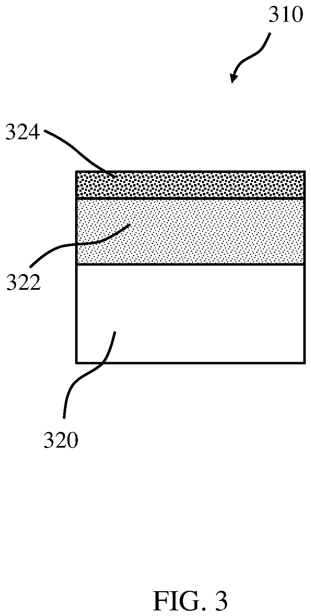

With reference to **FIG. 3****,** there is shown a side view of a CSP light emitting device 310 in accordance with another embodiment of the invention. In this embodiment, a first photoluminescence material layer **322** comprising a manganese-activated fluoride narrowband red phosphor is disposed directly on a light emitting face of a blue LED die **320.** Further, a second photoluminescence material layer **324** comprising a broadband green phosphor disposed onto the first photoluminescence material layer **322.** The light emitting device **310** functions and exhibits the same advantages as discussed in relation the light emitting device of **FIG. 1****,** for example. Hence, the statement made in relation to **FIG. 1** apply equally to the embodiment of **FIG. 3****.**

It will be understood that, in other embodiments, the light emitting device may comprise a single layer photoluminescence structure. In this way, the single layer may comprise a mixture of the manganese-activated fluoride narrowband red phosphor and the broadband green phosphor. An example of such a single layer photoluminescence structure is shown in Figures 2 and 3 and the accompanying text in paragraphs [0079]-[0087] of US Patent Publication Number US 2024/0120448 A1, which is hereby incorporated by way of reference.

### Broadband green phosphor materials

In this patent specification, a green phosphor material refers to a photoluminescence material (phosphor) which, in response to stimulation by excitation light, generates light having a peak emission wavelength (λₚₑ) from about 500 nm to about 565 nm (more typically from 520 nm to 550 nm), that is in the green region of the visible spectrum. Preferably the green phosphor has a broad emission characteristic with a FWHM (Full Width at Half Maximum) of ~100 nm or wider. The green phosphor can comprise garnet-based phosphor such as YAG or LuAG phosphors. Examples of suitable green phosphors are given in **Table 1.**

In embodiments, the green phosphor comprises a cerium-activated yttrium aluminum garnet phosphor of general composition (Y,Ba)₃(Al,Ga)₅O₁₂:Ce (YAG) such as, for example, a GNYAG series phosphor from Intematix Corporation, Fremont California, USA. In this patent specification, the notation YAG# represents the phosphor type - YAG - based phosphors - followed by the peak emission wavelength in nanometers (#). For example, YAG535 denotes a YAG phosphor with a peak emission wavelength of 535 nm.

In some embodiments, the phosphor can comprise a cerium-activated lutetium aluminum garnet (LuAG) of general composition Lu₃Al₅O₁₂:Ce (GAL). Examples of such phosphors include for example the GAL series of phosphor from Intematix Corporation, Fremont California, USA which have a peak emission wavelength of 516 nm to 560 nm and a FWHM of ~120 nm. In this patent specification, the notation GAL# represents the phosphor type (GAL) - LuAG - based phosphors - followed by the peak emission wavelength in nanometers (#). For example, GAL520 denotes a GAL phosphor with a peak emission wavelength of 520 nm.

In embodiments, the green phosphor comprises a europium-activated silicate phosphor of general composition A₂SiO₄:Eu (Sil) where A = Mg, Ca, Sr, Ba such as, for example, EG and G series Silicate phosphor from Intematix Corporation, Fremont California, USA. In this patent specification, the notation SIL# represents the phosphor type - SIL - based phosphors - followed by the peak emission wavelength in nanometers (#). For example, SIL525 denotes a silicate phosphor with a peak emission wavelength of 525 nm.

| **Table 1** - Example broadband green phosphors | | |
|---|---|---|
| Phosphor | General Composition | |
| GNYAG | (Y,Ba)₃₋ₓ(Al_{1-y}Ga_{y})₅O₁₂:Ceₓ | 0.01<x<0.2 & 0<y<2.5 |
| LuAG | Lu₃₋ₓ(Al_{1-y}M_{y})₅O₁₂:Ceₓ | 0.01<x<0.2 & 0<y<1.5, M = Mg, Ca, Sr, Ba, Ga |
| LuAG | Lu₃₋ₓ(Al_{1-y}Ga_{y})₅O₁₂:Cex | 0.01<x<0.2 & 0<y<1.5 |
| Silicate | A₂SiO₄:Eu | A = Mg, Ca, Sr, Ba |
| Silicate | (Sr₁₋ₓBaₓ)₂SiO₄:Eu | 0.3<x<0.9 |

### Broadband orange phosphor materials

In this patent specification, an orange phosphor refers to a photoluminescence material (phosphor) which, in response to stimulation by excitation light, generates light having a peak emission wavelength from 590 nm to 625 nm; that is light in the orange region of the visible spectrum. Preferably, the orange phosphor has a broad emission characteristic with a full width at half maximum (FWHM) emission intensity of at least 50 nm. The orange phosphor material can include for example a europium activated silicon nitride-based phosphor, or silicate-based phosphors. Examples of broadband orange phosphors are given in **Table 2.**

In some embodiments, the europium-activated silicon nitride-based phosphor comprises a **C**alcium **A**luminum **S**ilicon **N**itride phosphor (CASN) of general composition CaAlSiN₃:Eu²⁺. The CASN phosphor can be doped with other elements such as strontium (Sr) and have a general formula (Sr,Ca)AlSiN₃:Eu²⁺. In this patent specification, the notation CASN# represents the phosphor type (CASN) followed by the peak emission wavelength (λₚₑ) in nanometers (#). For example, CASN615 denotes an orange to red CASN phosphor with a peak emission wavelength of 615 nm.

In some embodiments, a broadband orange phosphor can comprise a europium-activated nitride-based phosphor of general composition (Ba,Sr)₂Si₅N₈:Eu.

In embodiments, the broadband orange phosphor comprises a europium-activated silicate phosphor of general composition (Ba,Sr)₃SiO₅:Eu (SIL) such as, for example, O series Silicate phosphors from Intematix Corporation, Fremont California, USA.

| **Table 2** - Example broadband orange phosphors | | |
|---|---|---|
| Phosphor | General Composition | |
| CASN | (Ca₁₋ₓSrₓ)AlSiN₃:Eu | 0.5<x≤1 |
| 258 Nitride | Ba₂₋ₓSrₓSi₅N₈:Eu | 0≤x≤2 |
| Silicate | (Ba₁₋ₓSrₓ)₃SiO₅:Eu | 0≤x≤0.5 |
| Silicate | (BaₓY_{y}Sr_{1-x-y})₃(Al_{y}Si_{1-y})O₅:Eu | 0≤x≤0.2, 0≤y≤0.4 |

### Narrowband red phosphor materials

In this patent specification, a narrowband red phosphor material refers to a photoluminescence material which, in response to stimulation by excitation light, generates light having a peak emission wavelength from 628 nm to 640 nm; that is light in the red region of the visible spectrum and which has a narrow emission characteristic with a full width at half maximum (FWHM) emission intensity from about 5 nm to about 30 nm. As described above, the narrowband red phosphor can comprise a manganese-activated narrowband red fluoride phosphor. An example of a manganese-activated narrowband red fluoride phosphor is manganese-activated potassium hexafluorosilicate phosphor (KSF) - K₂SiF₆:Mn⁴⁺ (KSF). An example of such a KSF phosphor is NR6931 series KSF phosphor from Intematix Corporation, Fremont California, USA which has a peak emission wavelength of about 632 nm. Other manganese-activated phosphors can include: K₂GeF₆:Mn⁴⁺ (KGF), K₂TiF₆:Mn⁴⁺ (KTF), Na₂SiF₆:Mn⁴⁺ (NSF), Na₂GeF₆:Mn⁴⁺ (NGF), Na₂TiF₆:Mn⁴⁺ (NTF), NaKSiF₆:Mn⁴⁺ (NKSF), NaKGeF₆:Mn⁴⁺ (NKGF), and NaKTiF₆:Mn⁴⁺ (NKTF).

### Nomenclature

In this specification, the nomenclature Dev.# denotes light emitting devices in accordance with embodiments for generating high gamut index (R_{g}) light.

### Packaged light emitting device test method

The packaged test method involves measuring total light emission of a packaged light emitting device in an integrating sphere.

### 2700K white light emitting devices

Packaged light emitting devices in accordance with the invention (Dev.1 to Dev.11) each comprise a 1734 package devices with a two-layer photoluminescence layer structure (**FIG. 1**) and contain a blue LED chip of dominant wavelength λ_{d} (450 nm to 452.5 nm). In the case of Dev.11, this contains 3 blue LED chips connected in series. The narrowband red phosphor is provided in the first photoluminescence layer and the other phosphor(s) (green phosphor and optionally orange phosphor) in the second photoluminescence layer.

**Table 3** tabulates phosphor compositions for 2700K nominal color temperature light emitting device denoted Dev.1 to Dev.11 in accordance with the invention in which: devices Dev.1 to Dev.3 are configured to generate white light with a target (minimum) general color rendering index (CRI Ra) of 70; Dev.4 and Dev.5 are configured to generate white light with a target (minimum) CRI Ra of 80; and Dev.6 to Dev.11 are configured to generate white light with a target (minimum) CRI Ra of 90.

For example, as can be seen from **Table 3,** in terms of phosphor composition: Dev.1 comprises 64.8 wt% KSF (narrowband red phosphor - e.g. KSF, but equally may be constituted by one or a combination of K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺), 34.6 wt% SIL525 (Green silicate phosphor with a peak emission wavelength λₚₑ of 525 nm), and 0.6 wt% CASN615 (Orange nitride phosphor with a peak emission wavelength λₚₑ of 615 nm). The ratio of orange phosphor (CASN615) to the sum of orange phosphor (CASN615) and narrowband red phosphor (KSF) is 0.9%.

As can be seen from **Table 3,** devices in accordance with the invention can, depending on the target CRI Ra, comprise from 55% to 75% narrowband red phosphor (e.g. KSF, but equally may be constituted by one or a combination of K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺), 45% to 25% green phosphor, and may additionally comprise 0.5% to 4.5% orange phosphor. Although the values are for devices that are for generating white light with a target CCT of 2700K, test data indicates that similar ranges apply to devices that are for generating white light with a CCT from 2200K to about 3000K.

| **Table 3** - 2700K White light emitting device phosphor composition | | | | | | | |
|---|---|---|---|---|---|---|---|
| Device | Target (min.) CRI Ra | Phosphor composition | | | | | |
| | | Green (wt%) | | | Red (wt%) | Orange (wt%) | Ratio CASN615: (KSF + CASN615) |
| | | SIL525 | YAG535 | YAG542 | KSF | CASN615 | |
| Dev.1 | 70 | 34.6 | - | - | 64.8 | 0.6 | 0.9% |
| Dev.2 | 70 | - | 35.4 | - | 64.6 | - | 0.0% |
| Dev.3 | 70 | 25.9 | - | - | 71.5 | 2.6 | 3.5% |
| Dev.4 | 80 | - | - | 26.1 | 73.9 | - | 0.0% |
| Dev.5 | 80 | 26.1 | - | - | 73.9 | - | 0.0% |
| Dev.6 | 90 | 31.7 | - | - | 65.4 | 2.9 | 4.2% |
| Dev.7 | 90 | - | 30.4 | - | 67.4 | 2.2 | 3.2% |
| Dev.8 | 90 | - | 38.3 | - | 58.4 | 3.3 | 5.3% |
| Dev.9 | 90 | - | - | 36.2 | 59.6 | 4.2 | 6.6% |
| Dev.10 | 90 | - | 30.7 | - | 66.4 | 2.7 | 3.9% |
| Dev.11 | 90 | - | - | 37.7 | 64.9 | 3.4 | 5.0% |

**Table 4** tabulates measured test data for light emitting devices Dev.1 to Dev.11 in accordance with the invention. Rows including shading (i.e., Dev.3 - CRI Ra 70, Dev.4 - CRI Ra 80, and Dev.9 - CRI Ra 90) indicate that these devices have been optimized for both Gamut index (R_{g}) and for Luminous Efficacy of Radiation (LER). These devices may be optimized by the selection of the color point (chromaticity CIE 1931 x, y) of light generated by the device which will depend on selected color temperature and by the choice of phosphor and relative quantity of phosphors.

As can be seen from **Table 4,** devices in accordance with the invention can, depending on the target CRI Ra, have a Luminous Efficacy of Radiation (LER) from about 300 lm/Wₒₚₜ to about 330 lm/Wₒₚₜ (300.6 to 326.2 lm/Wₒₚₜ), that is at least 300 lm/Wₒₚₜ, and generate light having: (i) a Gamut index (R_{g}) from about 105 to about 120 (106.5 to 118.9), that is gamut index, R_{g}, of at least 105, (ii) a General Color Rendering Index, CRI Ra, from about 70 to 95 (72.2 to 93.9), that is at least 70, (iii) a Color Rendering Index, CRI R9, from about 30 to 95 (31.1 to 95.1), that is at least 30, and (iv) a CIE 1976 Dᵤᵥ of -0.005 to -0.015 (-0.0054 to - 0.0129).

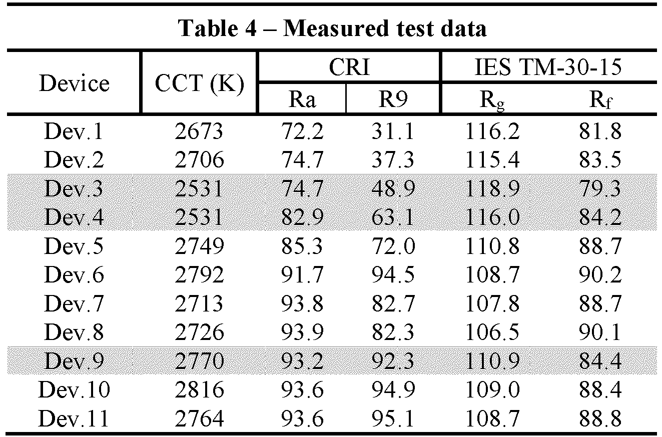

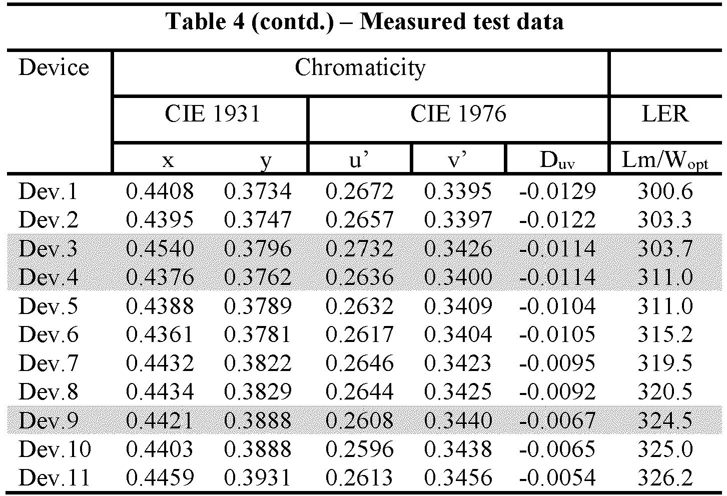

### Spectral Characteristics

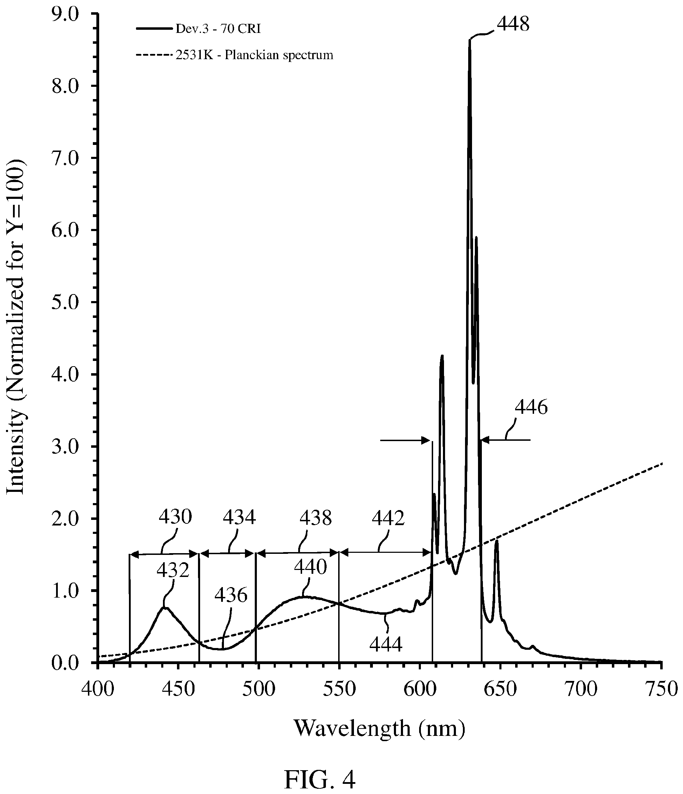

The spectral characteristics of light emitting devices in accordance of the invention are described with reference to **FIGS. 4** to **6** which respectively show spectra, normalized intensity (a.u.) versus wavelength (nm), for light emitting devices Dev.3, Dev.4, and Dev.9 (solid line) and a Planckian (blackbody) radiator (dashed line) of temperature that is the same as the CCT of the device.

**FIG. 4** shows spectra, normalized intensity (a.u.) versus wavelength (nm), for light emitting device Dev.3 - CRI 70 (solid line) and a Planckian (blackbody) radiator (dashed line) of temperature T that is the same as the CCT of Dev.3 (2531 K).

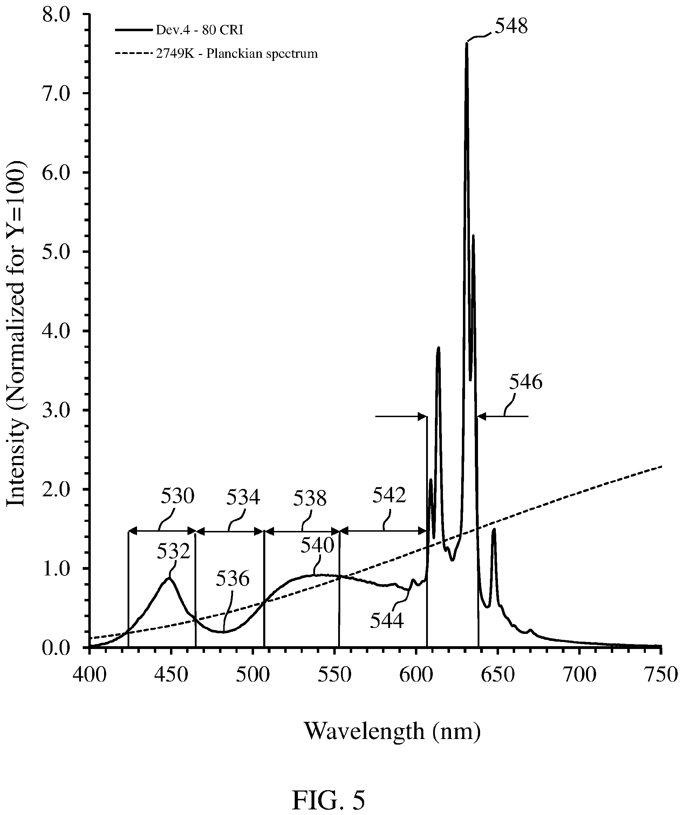

**FIG. 5** shows spectra, normalized intensity versus wavelength (nm) for light emitting device Dev.4 - CRI 80 (solid line) and Planckian (blackbody) radiator (dashed line) of temperature T that is the same as the CCT of Dev.3 (2531 K).

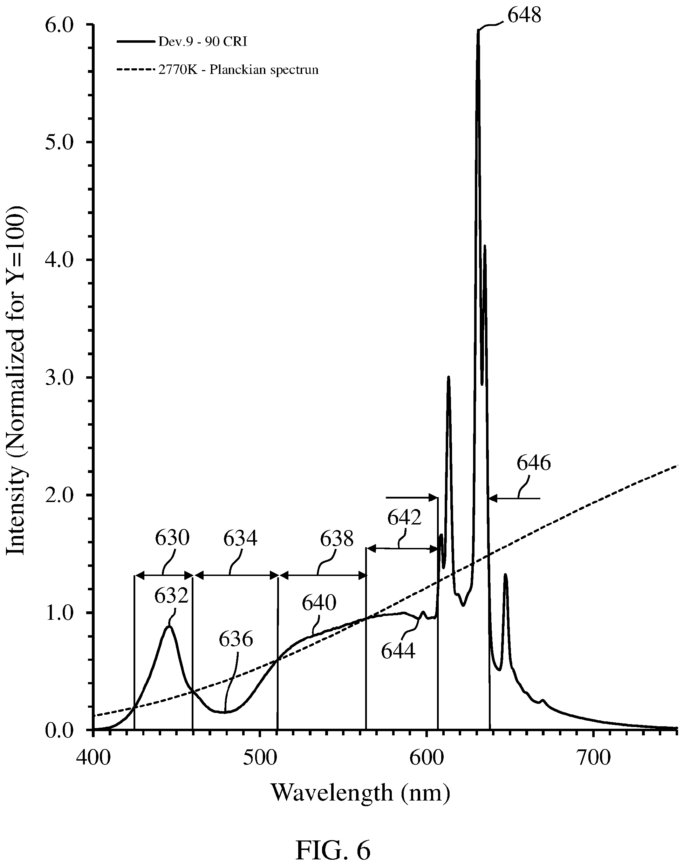

**FIG. 6** shows spectra, normalized intensity (a.u.) versus wavelength (nm), for: (i) light emitting device Dev.9 - CRI 90 (solid line) and Planckian (blackbody) radiator (dashed line) of temperature T that is the same as the CCT of Dev.4 (2770 K).

To enable comparison of the spectra (i.e., measured and Planckian spectra), each spectrum has been normalized such that each has a CIE 1931 XYZ relative luminance Y=100. The data are normalized using the CIE 1931 luminosity function y(λ) of a standard observer which takes account of the photopic response of an observer. The Planckian (blackbody) spectrum for a given temperature T corresponds to a CIE General CRI (Ra), IES TM-30-15 Gamut Index Rg and Fidelity Index Rf equal to 100 for that temperature.

Referring to **FIG. 4****,** though it will be understood that the following applies equally to **FIGS. 5** and **6****,** the intensity versus wavelength spectrum of light generated by devices according to the invention exhibit, in order from shorter wavelengths (Blue) to longer wavelengths (Red), five spectral characteristics (features): (i) in a blue wavelength region of the spectrum (Blue region) **430** a first spectral feature (peak) **432,** (ii) in a cyan wavelength region of the spectrum (Cyan region) **434** a second spectral feature (trough) **436,** (iii) in a green wavelength region of the spectrum (Green region) **438** a third spectral feature (peak) **440,** (iv) in a yellow to orange wavelength region of the spectrum (Yellow/Orange region) **442** a fourth spectral feature (trough) **444,** and (v) in a red wavelength region of the spectrum (Red region) **446** a fifth spectral feature (multiple peaks) **448.**

As shown in **FIG. 4****,** the intensity of the spectral features **432, 440, 448** in the Blue region, Green region, and Red region respectively is greater than the intensity of the Planckian spectrum P.S. (dashed line). Conversely, as shown in **FIG. 4** the intensity of the spectral features **436, 444** in the Cyan region, and Yellow/Orange region is less than the intensity of the Planckian spectrum P.S. (dashed line).

As described herein, an intensity that is greater than the intensity of the Planckian spectrum is indicative of increased color saturation in this wavelength region of the spectrum. Since the intensity in both the Green and Red wavelength regions of the spectrum is greater than the intensity of the Planckian spectrum indicates increased color saturation of both green and red light which can increase the gamut index (R_{g}) of light generated by the device. Conversely, since the intensity in the Yellow/Orange region of the spectrum is less than intensity of the Planckian spectrum indicates decreased color saturation in this wavelength region which it is postulated enhances color contrast between red and green light leading to a perceived improvement in light quality.

### Spectral Characterization

Parameters used to characterize the spectral features (characteristics) of the various wavelength regions are provided in this section.

"**Δλ**>" is a wavelength range for which the intensity of light generated by the device (I_{Dev}) is greater than (>) the intensity of the Planckian Spectrum (I_{PS}) and is applicable to the Blue region, Green region, and the Red region. For example, for device Dev.3, in the Green region the wavelength range Δλ> is 497 nm to 549 nm (**Table 5c**).

"**λ_{maxI}**" is a wavelength of maximum intensity of light generated by the device (I_{Dev}) in the wavelength range Δλ> and is applicable to the Blue region, Green region, and the Red region. For example, for device Dev.3, in the Green region the wavelength of maximum intensity λ_{maxI} is 530 nm (**Table 5c**).

"**Iₘₐₓ**" is an intensity of light generated by the device (I_{Dev}) at λ_{maxI} and is applicable for the Blue region, Green region, and the Red region. For example, for device Dev.3, in the Green region the maximum intensity of light generated by the device Iₘₐₓ is 0.9135 (**Table 5c**). In the case of the Red region, Iₘₐₓ is the intensity of the highest emission peak #48 (**FIGS. 4** to **6**).

"**Δλ**<" is a wavelength range for which the intensity of light generated by the device (I_{Dev}) is less than (<) the intensity of the Planckian Spectrum (I_{PS}) and is applicable to the Cyan region and Yellow/Orange region. For example, for device Dev.3, in the Yellow/Orange region the wavelength range Δλ< is 550 nm to 607 nm (**Table 5d**).

"**λ_{minI}**" is the wavelength of minimum intensity of light generated by the device (I_{Dev}) in the wavelength range Δλ< and is applicable to the Cyan region, and the Yellow/Orange region. For example, for device Dev.3, in the Yellow/Orange region λ_{minI} is 578 nm (**Table 5d**).

"**Iₘᵢₙ**" is an intensity of light generated by the device (I_{Dev}) at λ_{minI} and is applicable to the Cyan region, and the Yellow/Orange region. For example, for device Dev.3, in the Yellow/Orange region the minimum intensity of light generated by the device Iₘᵢₙ is 0.6837 (**Table 5d**).

"**λ_{maxΔI}**" is the wavelength of maximum difference between the intensity of light generated by the device (I_{Dev}) and the intensity of the Planckian Spectrum (I_{PS}) within a wavelength region Δλ>, Δλ< and is applicable to the Blue region, Cyan region, Green region, Yellow/Orange and the Red region. For example, for device Dev.3, in the Green region λ_{maxΔI} is 516 nm and in the Yellow/Orange region is 594 nm (**Tables 5c** and **5d**).

"**I_{maxΔ}**" is the intensity of light generated by the device (I_{Dev}) at λ_{maxΔI} and is applicable to the Blue region, Cyan region, Green region, Yellow/Orange region and the Red region. For example, for device Dev.3, in the Green region **I_{maxΔ}** is 0.8366 and in the Yellow/orange region is 0.7073 (**Table 5c** and **5d**).

"**ΔIₘₐₓ**" is a percentage ratio of the intensity of light generated by the device (I_{Dev}) and the intensity of the Planckian Spectrum (I_{PS}) at λ_{maxΔI} and is applicable to the Blue region, Cyan region, Green region, Yellow/Orange region and the Red region. For the Blue region, Green region, and Red region in which the intensity of light generated by the device is greater than the intensity of the Planckian Spectrum, ΔIₘₐₓ will have a value of greater than 100%. For the Cyan region, and yellow/Orange region in which the intensity of light generated by the device is less than the intensity of the Planckian Spectrum, ΔIₘₐₓ will have a value of less than 100%. For example, for device Dev.3, in the Green region **ΔIₘₐₓ** is 146% (i.e., I_{Dev} is 46% greater than I_{PS}) and in the Yellow/orange region **ΔIₘₐₓ** is 58% (i.e., I_{Dev} is -42% less than I_{PS}) (**Table 5c** and **5d**). In Tables **5a** to **5e** the values of **ΔIₘₐₓ** in parentheses are maximum percentage difference (deviation) of I_{Dev} from I_{PS} (i.e., ΔIₘₐₓ-100).

"RIₘₐₓ" is a maximum intensity of light generated by the device in the Red region.

"GIₘₐₓ" is a maximum intensity of light generated by the device in the Green region.

"BIₘₐₓ" is a maximum intensity of light generated by the device in the Blue region.

"CIₘᵢₙ" is a minimum intensity of light generated by the device in the Cyan region.

"OIₘᵢₙ" is a minimum intensity of light generated by the device in the Yellow/Orange region.

| **Table 5a** - **Measured spectral characteristics** | | | | | | |
|---|---|---|---|---|---|---|
| Blue region **#30:** I_{Dev} > I_{PS} (Peak #**32**) | | | | | | |
| Device | Δλ> (nm) | λ_{maxI} (nm) | Iₘₐₓ (a.u.) | λ_{maxΔI} (nm) | I_{maxΔ} (a.u) | ΔI_{maxΔ} (%) |
| Dev.3 | 422 - 462 | 441 | 0.7614 | 440 | 0.7554 | 398 (298) |
| Dev.4 | 423 - 465 | 447 | 0.8561 | 447 | 0.8561 | 320 (220) |
| Dev.9 | 425 - 465 | 445 | 0.8802 | 444 | 0.8695 | 333 (233) |

| **Table 5b** - **Measured spectral characteristics** | | | | | | |
|---|---|---|---|---|---|---|
| Cyan region **#34:** I_{Dev} < I_{PS} (trough **#36**) | | | | | | |
| Device | Δλ< (nm) | λ_{minI} (nm) | Iₘᵢₙ (a.u.) | λ_{maxΔI} (nm) | I_{maxΔ} (a.u) | ΔI_{maxΔ} (%) |
| Dev.3 | 463 - 496 | 476 | 0.1841 | 478 | 0.1858 | 53 (-47) |
| Dev.4 | 466 - 507 | 482 | 0.1917 | 484 | 0.1978 | 45 (-55) |
| Dev.9 | 460 - 510 | 479 | 0.1494 | 482 | 0.1547 | 36 (-64) |

| **Table 5c** - **Measured spectral characteristics** | | | | | | |
|---|---|---|---|---|---|---|
| Green region **#38:** I_{Dev} > I_{PS} (Peak #**40**) | | | | | | |
| Device | Δλ> (nm) | λ_{maxI} (nm) | Iₘₐₓ (a.u.) | λ_{maxΔI} (nm) | I_{maxΔ} (a.u) | ΔI_{maxΔ} (%) |
| Dev.3 | 497 - 549 | 530 | 0.9135 | 516 | 0.8366 | 146 (46) |
| Dev.4 | 508 - 555 | 542 | 0.9195 | 524 | 0.8532 | 126 (26) |
| Dev.9 | 511 - 564 | 564 | 0.9515 | 528 | 0.7861 | 111 (11) |

| **Table 5d - Measured spectral characteristics** | | | | | | |
|---|---|---|---|---|---|---|
| Yellow/Orange region #**42**: I_{Dev} < I_{PS} (trough #**44**) | | | | | | |
| Device | Δλ< (nm) | λ_{minI} (nm) | Iₘᵢₙ (a.u.) | λ_{maxΔI} (nm) | I_{maxΔ} (a.u) | ΔI_{maxΔ} (%) |
| Dev.3 | 550 - 607 | 578 | 0.6837 | 594 | 0.7053 | 58 (-42) |
| Dev.4 | 556 - 608 | 595 | 0.7286 | 595 | 0.7286 | 52 (-38) |
| Dev.9 | 565 - 607 | 595 | 0.9466 | 606 | 0.8752 | 79 (-21) |

| **Table 5e** - **Measured spectral characteristics** | | | | | | |
|---|---|---|---|---|---|---|
| Red region #**46**: I_{Dev} > I_{PS} (Multiple Peaks #**48**) | | | | | | |
| Device | Δλ> (nm) | λ_{maxI} (nm) | Iₘₐₓ (a.u.) | λ_{maxΔI} (nm) | I_{maxΔ} (a.u) | ΔI_{maxΔ} (%) |
| Dev.3 | 608 - 637 | 631 | 8.6325 | 631 | 8.6325 | 552 (452) |
| Dev.4 | 609 - 637 | 631 | 7.6286 | 631 | 7.6286 | 525 (425) |
| Dev.9 | 608 - 637 | 631 | 5.9346 | 631 | 5.9346 | 411 (311) |

| **Table 5f - Measured spectral characteristics** | | | | | |
|---|---|---|---|---|---|
| Device | Ratio of intensity of spectral features | | | | |
| | RIₘₐₓ:GIₘₐₓ | RIₘₐₓ:OIₘᵢₙ | GIₘₐₓ:OIₘᵢₙ | BIₘₐₓ:CIₘᵢₙ | GIₘₐₓ:BIₘᵢₙ |
| Dev.3 | 9.45 | 12.63 | 1.34 | 4.14 | 1.19 |
| Dev.4 | 8.30 | 10.47 | 1.26 | 4.47 | 1.07 |
| Dev.9 | 6.24 | 6.27 | 1.01 | 5.89 | 1.08 |

Light emitting devices in accordance with the invention can generate light with an intensity wavelength spectrum containing one or more of the five spectral features described herein.

As described herein light emitting devices according to embodiments may be for generating light of a selected color temperature having an intensity versus wavelength spectrum comprising: an intensity in a Green region of the spectrum that is greater than an intensity of the Planckian spectrum of the same selected color temperature; an intensity in a yellow to orange region of the spectrum that is less than an intensity of the Planckian spectrum of the same selected color temperature; and an intensity in a Red region of the spectrum that is greater than an intensity of the Planckian spectrum of the same selected color temperature. It is postulated that such a spectral characteristic may increase gamut index R_{g} and increase red/green contrast which is perceived as being an improvement in light quality.

For devices generating light having such a spectral characteristic, a maximum intensity of light in the Green region may be 110% to 150% of the intensity of the Planckian spectrum (ΔI_{maxΔ}: 111% to 146% **-Table 5c**); a minimum intensity of light in Yellow/Orange region may be 50% to 80% of the intensity of the Planckian spectrum (ΔI_{maxΔ}: 52% to 79% - **Table 5d**); and/or a maximum intensity of light in the Red region may be 400% to 600% of the intensity of the Planckian spectrum (ΔI_{maxΔ}: 411% to 552% - **Table 5e**).

The Green region may be in a wavelength range from 500 nm to 570 nm (Δλ>: 497 nm to 564 nm - **Table 5c**); the Yellow/Orange region may be in a wavelength range (Δλ<) from 550 nm to 608 nm (Δλ<: 550 nm to 608 nm - **Table 5d**); the Red region may be in a wavelength range from 608 nm to 640 nm (Δλ>: 608 nm to 637 nm - **Table 5e**).

Light emitting devices in accordance with the invention can generate light with an intensity wavelength spectrum in which a ratio of a maximum intensity in Red region of the spectrum to a minimum intensity in the Yellow/Orange region of the spectrum is from about 5.0 to about 15.0 (RIₘₐₓ:GIₘₐₓ 6.27 to 12.63 - **Table 5f**).

Where the device is for generating light with a CRI Ra of at least 70 a ratio of a maximum intensity in Red region of the spectrum to a minimum intensity in the Yellow/Orange region of the spectrum may be from about 11.0 to about 15.0.

Where the device is for generating light with a CRI Ra of at least 80 a ratio of a maximum intensity in Red region of the spectrum to a minimum intensity in the Yellow/Orange region of the spectrum may be from about 8.0 to 11.0.

Where the device is for generating light with a CRI Ra of at least 90 a ratio of a maximum intensity in Red region of the spectrum to a minimum intensity in the Yellow/Orange region of the spectrum may be from about 5.0 to 8.0.

Light emitting devices according to the invention may generate light with an intensity versus wavelength spectrum in which a ratio of a maximum intensity in a Red region of the spectrum to a maximum intensity in a Green region of the spectrum is from about 6.0 to about 10.0 (RIₘₐₓ:GIₘₐₓ 6.24 to 9.45 - **Table 5f**).

Alternatively, or in addition light emitting devices according to the invention can generate light with an intensity versus wavelength spectrum in which or a ratio of a maximum intensity in Green region of the spectrum to a minimum intensity in the Yellow/Orange region of the spectrum is from about 1.0 to about 1.5 (GIₘₐₓ:OIₘᵢₙ 1.01 to 1.34 - **Table 5f**).

Alternatively, or in addition light emitting devices according to the invention can generate light with an intensity versus wavelength spectrum in which or a ratio of a maximum intensity in Blue region of the spectrum to a minimum intensity in the Cyan region of the spectrum is from about 4.0 to about 6.0 (BIₘₐₓ:CIₘᵢₙ 4.14 to 5.89 - **Table 5f**).

Alternatively, or in addition light emitting devices according to the invention can generate light with an intensity versus wavelength spectrum in which or a ratio of a maximum intensity in Green region of the spectrum to a maximum intensity in the Blue region of the spectrum is from about 1.0 to about 1.2 (GIₘₐₓ:BIₘᵢₙ 1.07 to 1.19 - **Table 5f**).

The Blue region may be in a wavelength range from 420 nm to 470 nm (Δλ>: 422 nm to 465 nm - **Table 5a**); and the Cyan region may be in a wavelength range (Δλ<) from 460 nm to 510 nm (Δλ<: 460 nm to 510 nm - **Table 5b**).

In summary, it will be appreciated that light emitting devices in accordance with the invention may comprise an LED for generating blue light; a green phosphor for generating green light; and a manganese activated fluoride narrowband phosphor for generating red light, and have one or more of the following features: (i) the device is for generating light having an intensity versus wavelength spectrum with a ratio of a maximum intensity in the red region of the spectrum to a minimum intensity in the yellow to orange region of the spectrum is from about 5.0 to about 15.0; (ii) the device is for generating light having an intensity versus wavelength spectrum in which at least one of the following applies: the ratio of the maximum intensity in the red region of the spectrum to the minimum intensity in the yellow to orange region of the spectrum is about 11.0 to about 15.0 and the device is for generating light with a CRI Ra of at least 70; the ratio of the maximum intensity in red region of the spectrum to the minimum intensity in the yellow to orange region of the spectrum is about 8.0 to about 11.0 and the device is for generating light with a CRI Ra of at least 80; and the ratio of the maximum intensity in red region of the spectrum to the minimum intensity in the yellow to orange region of the spectrum is about 5.0 to about 8.0 and the device is for generating light with a CRI Ra of at least 90; (iii) the device is for generating light having an intensity versus wavelength spectrum in which at least one of the following applies: a ratio of a maximum intensity in a red region of the spectrum to a maximum intensity in a green region of the spectrum is from 6.0 to 10.0; a ratio of a maximum intensity in a green region of the spectrum to a minimum intensity in a yellow to orange region of the spectrum is about 1.0 to about 1.5; a ratio of a maximum intensity in a blue region of the spectrum to a minimum intensity in a cyan region of the spectrum is from about 4.0 to about 6.0; and a ratio of a maximum intensity in a green region of the spectrum to a maximum intensity in a blue region of the spectrum is from about 1.0 to about 1.2; (iv) the device is for generating light of a selected color temperature having an intensity versus wavelength spectrum comprising: an intensity in a green region of the spectrum that is greater than an intensity of the Planckian spectrum of the selected color temperature; an intensity in a yellow to orange region of the spectrum that is less than an intensity of the Planckian spectrum of the selected color temperature; and an intensity in a red region of the spectrum that is greater than an intensity of the Planckian spectrum of the selected color temperature; and wherein at least one of following applies: a maximum intensity in the green region is 110% to 150% of the intensity of the Planckian spectrum; a minimum intensity in the yellow to orange region is 50% to 80% of the intensity of the Planckian spectrum; and a maximum intensity in the red region is 400% to 600% of the intensity of the Planckian spectrum; (v) the device is for generating light having an intensity versus wavelength spectrum in which the green region is from 500 nm to 565 nm; the yellow to orange region is from 550 nm to 609 nm; and the red region is from 605 nm to 640 nm; (vi) the device has a Luminous Efficacy of Radiation, LER, of at least 300 lm/Wₒₚₜ (vii) the device has an LER from 300 lm/Wₒₚₜ to 330 lm/Wₒₚₜ; (viii) the device is for generating light with an IES TM-30-15 Gamut Index, R_{g}, of at least 105; (ix) the device is for generating light with an R_{g} from 105 to 120; (x) at least one of the following applies: the device has an LER from 300 lm/Wₒₚₜ to 305 lm/Wₒₚₜ and is for generating light with a CRI Ra of at least 70 and an R_{g} of 115 to 120; the device has an LER from 305 lm/Wₒₚₜ to 315 lm/Wₒₚₜ and is for generating light with a CRI Ra of at least 80 and an R_{g} of 115 to 120; and the device has an LER from 315 lm/Wₒₚₜ to 330 lm/Wₒₚₜ and is for generating light with a CRI Ra of at least 90 and an R_{g} of 105 to 115; (xi) the manganese activated fluoride narrowband phosphor comprises from 55 wt% to 75 wt% of a total phosphor content; (xii) the green phosphor comprises from 25 wt% to 45 wt% of a total phosphor content; (xiii) comprises an orange phosphor for generating orange light, optionally with a peak emission wavelength from 600 nm to 620 nm, and optionally the orange phosphor comprises from 25 wt% to 45 wt% of a total phosphor content; and (xiv) the manganese activated fluoride narrowband phosphor is selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.
- Δλ>: Wavelength range for which intensity of Device (I_{Dev}) is greater than (>) intensity of the Planckian Spectrum (I_{PS})
- Δλ<: wavelength range for which intensity of Device (I_{Dev}) is less (<) than the intensity of the Planckian Spectrum (I_{PS})
- λ_{minI}: Wavelength of minimum intensity
- λ_{maxI}: Wavelength of maximum intensity
- λ_{maxΔI}: Wavelength for maximum intensity difference between intensity of Device (I_{Dev}) and intensity of the Planckian Spectrum (I_{PS})
- ΔIₘₐₓ: Maximum intensity difference between Intensity of Device (I_{Dev}) and the Intensity of the Planckian Spectrum (I_{PS})
- I_{Dev}: Intensity of Device
- I_{PS}: Intensity of Planckian Spectrum
- Iₘₐₓ: Intensity at wavelength of maximum intensity (λ_{maxI})
- Iₘᵢₙ: Intensity at wavelength of minimum intensity (λ_{minI})
- BIₘₐₓ: Intensity at wavelength of maximum intensity (λ_{maxI}) in Blue region
- CIₘₐₓ: Intensity at wavelength of minimum intensity (λ_{maxI}) in Cyan region
- GIₘₐₓ: Intensity at wavelength of maximum intensity (λ_{maxI}) in Green region
- OIₘₐₓ: Intensity at wavelength of minimum intensity (λ_{minI}) in Yellow/Orange region
- RIₘₐₓ: Intensity at wavelength of maximum intensity (λ_{maxI}) in Red region

### Reference numerals

- #10: Light emitting device
- #12: Package
- #14: Base
- #16: Side wall
- #18: Cavity (cup)
- #20: LED
- #22: First photoluminescence layer
- #24: Second photoluminescence layer
- #30: Blue region - blue region of the spectrum
- #32: First spectral feature (peak)
- #34: Cyan region - cyan region of the spectrum
- #36: Second spectral feature (trough)
- #38: Green region - green region of the spectrum
- #40: Third spectral feature (peak)
- #42: Yellow to orange region - yellow to orange region of the spectrum
- #44: Fourth spectral feature (trough)
- #46: Red region - red region of the spectrum
- #48: Fifth spectral feature (maximum intensity peak)

## Claims

1. A light emitting device comprising:
an LED for generating blue light;
a green phosphor for generating green light; and
a manganese activated fluoride narrowband phosphor for generating red light;
wherein the device is for generating light having an intensity versus wavelength spectrum with a ratio of a maximum intensity in the red region of the spectrum to a minimum intensity in the yellow to orange region of the spectrum is from about 5.0 to about 15.0.

2. The device of Claim 1, wherein the manganese activated fluoride narrowband phosphor is selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

3. The device of Claim 1 or Claim 2, wherein the device has a Luminous Efficacy of Radiation, LER, of at least 300 lm/Wₒₚₜ and is for generating light with an IES TM-30-15 Gamut Index, R_{g}, of at least 105 or an IES TM-30-15 Gamut Index, R_{g}, from 105 to 120.

4. The device of any of Claims 1 to 3, wherein at least one of the following applies:
the ratio of the maximum intensity in the red region of the spectrum to the minimum intensity in the yellow to orange region of the spectrum is about 11.0 to about 15.0 and the device is for generating light with a CRI Ra of at least 70;
the ratio of the maximum intensity in red region of the spectrum to the minimum intensity in the yellow to orange region of the spectrum is about 8.0 to about 11.0 and the device is for generating light with a CRI Ra of at least 80; and
the ratio of the maximum intensity in red region of the spectrum to the minimum intensity in the yellow to orange region of the spectrum is about 5.0 to about 8.0 and the device is for generating light with a CRI Ra of at least 90.

5. The device of any of Claims 1 to 4, wherein at least one of the following applies:
a ratio of a maximum intensity in a red region of the spectrum to a maximum intensity in a green region of the spectrum is from 6.0 to 10.0;
a ratio of a maximum intensity in a green region of the spectrum to a minimum intensity in a yellow to orange region of the spectrum is about 1.0 to about 1.5;
a ratio of a maximum intensity in a blue region of the spectrum to a minimum intensity in a cyan region of the spectrum is from about 4.0 to about 6.0; and
a ratio of a maximum intensity in a green region of the spectrum to a maximum intensity in a blue region of the spectrum is from about 1.0 to about 1.2.

6. A light emitting device comprising:
an LED for generating blue light;
a green phosphor for generating green light; and
a manganese activated fluoride narrowband phosphor for generating red light;
wherein the device is for generating light of a selected color temperature having an intensity versus wavelength spectrum comprising:
an intensity in a green region of the spectrum that is greater than an intensity of the Planckian spectrum of the selected color temperature;
an intensity in a yellow to orange region of the spectrum that is less than an intensity of the Planckian spectrum of the selected color temperature; and
an intensity in a red region of the spectrum that is greater than an intensity of the Planckian spectrum of the selected color temperature; and
wherein at least one of following applies:
a maximum intensity in the green region is 110% to 150% of the intensity of the Planckian spectrum;
a minimum intensity in the yellow to orange region is 50% to 80% of the intensity of the Planckian spectrum; and
a maximum intensity in the red region is 400% to 600% of the intensity of the Planckian spectrum.

7. The device of Claim 6, wherein the manganese activated fluoride narrowband phosphor is selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

8. The device of Claim 6 or Claim 7, wherein the green region is from 500 nm to 565 nm; the yellow to orange region is from 550 nm to 609 nm; and the red region is from 605 nm to 640 nm.

9. The device of any of Claims 6 to 8, wherein the device has a Luminous Efficacy of Radiation, LER, of at least 300 lm/Wₒₚₜ and is for generating light with an IES TM-30-15 Gamut Index, R_{g}, of at least 105, or an IES TM-30-15 Gamut Index, R_{g}, from 105 to 120.

10. A light emitting device comprising:
an LED for generating blue light;
a green phosphor for generating green light; and
a manganese activated fluoride narrowband phosphor for generating red light;
wherein the device has a Luminous Efficacy of Radiation, LER, of at least 300 lm/Wₒₚₜ and is for generating light with an IES TM-30-15 Gamut Index, R_{g}, of at least 105.

11. The device of Claim 10, wherein the manganese activated fluoride narrowband phosphor is selected from the group consisting of: K₂SiF₆:Mn⁴⁺, K₂GeF₆:Mn⁴⁺, K₂TiF₆:Mn⁴⁺, Na₂SiF₆:Mn⁴⁺, Na₂GeF₆:Mn⁴⁺, Na₂TiF₆:Mn⁴⁺, NaKSiF₆:Mn⁴⁺, NaKGeF₆:Mn⁴⁺, and NaKTiF₆:Mn⁴⁺.

12. The device of Claim 10 or Claim 11, wherein the device is for generating light with an LER from 300 lm/Wₒₚₜ to 330 lm/Wₒₚₜ, and/or an R_{g} from 105 to 120.

13. The device of any of Claims 10 to 12, wherein at least one of the following applies:
the device has an LER from 300 lm/Wₒₚₜ to 305 lm/Wₒₚₜ and is for generating light with a CRI Ra of at least 70 and an R_{g} of 115 to 120;
the device has an LER from 305 lm/Wₒₚₜ to 315 lm/Wₒₚₜ and is for generating light with a CRI Ra of at least 80 and an R_{g} of 115 to 120; and
the device has an LER from 315 lm/Wₒₚₜ to 330 lm/Wₒₚₜ and is for generating light with a CRI Ra of at least 90 and an R_{g} of 105 to 115.

14. The device of any of Claims 10 to 13, wherein the manganese activated fluoride narrowband phosphor comprises from 55 wt% to 75 wt% of a total phosphor content.

15. The device of any of Claims 10 to 14, wherein the green phosphor comprises from 25 wt% to 45 wt% of a total phosphor content.

16. The device of any of Claims 10 to 15, comprising an orange phosphor for generating orange light, optionally the orange light has a peak emission wavelength from 600 nm to 620 nm, and optionally the orange phosphor comprises from 25 wt% to 45 wt% of a total phosphor content.
